# EUROPEAN PATENT APPLICATION

(11) **EP 4 529 369 A1**
(43) Date of publication of application: **26.03.2025**
(21) Application number: 23198894.0
(22) Date of filing: 21.09.2023
(51) Int. Cl.: H05K 3/00, H05K 3/22, H05K 1/02

(54) **A METHOD FOR FABRICATING AT LEAST ONE CONDUCTIVE STRUCTURE LAYER ON OR IN A COMPONENT CARRIER**

(71) Applicant: AT & S Austria Technologie & Systemtechnik Aktiengesellschaft, 8700 Leoben-Hinterberg (AT)
(72) Inventor: MAYR, Guenther, 8700 Leoben (AT)
(74) Representative: Burger, Hannes

(57) **Abstract**

The invention concerns a method for fabricating at least one conductive structure layer (6), preferably in the form of a trace, a pad, a land or a connecting lip, on or in a component carrier (7), preferably in the form of a printed circuit board or an integrated circuit substrate, and with at least one specific electric or electronic property, comprising the step of manufacturing a conductive structure layer (6) or changing or reworking a pre-fabricated conductive structure layer (6), based on at least one model (5) combining design parameters with at least one electric or electronic property, in particular the impedance,
wherein the method further comprises the steps of
- acquiring actual data from at least one conductive structure layer (6) of a component carrier (7),
- feeding said actual data of said at least one conductive structure layer (6) into the at least one model (5), said model (5) determining - in dependence of said actual data of said at least one conductive structure layer (6) and in dependence of at least one electric or electronic target property for the conductive structure layer (6) - at least one adjusted design parameter for the conductive structure layer (6), wherein the at least one adjusted design parameter relates to a geometric characteristic and/or a structural characteristic and/or a material characteristic of the conductive structure layer (6), in particular the structure layer width, the structure layer thickness, the structure layer length, the structure layer roughness, the structure layer porosity and/or the structure layer material,
wherein the step of manufacturing a conductive structure layer (6) or changing or reworking a pre-fabricated conductive structure layer (6) is performed according to the at least one adjusted design parameter.

## Description

The invention concerns a method for fabricating at least one conductive structure layer, preferably in the form of a trace, a pad, a land or a connecting lip, on or in a component carrier, preferably in the form of a printed circuit board or an integrated circuit (IC) substrate, according to the preamble of claim 1, to a computer-implemented method, further a production facility for fabricating a conductive structure layer, a computer program, and a computer readable medium.

Methods known so far for fabricating circuit traces on for instance printed circuit boards comprise standard subtractive techniques (for example etching subtractive), or additive techniques (for example mSAP, semi-additive). The conductive traces are part of at least one electrically conductive layer structure may comprise at least one of the group consisting of copper, aluminum, nickel, silver, gold, palladium, and tungsten. Although copper is usually preferred, other materials or coated versions thereof are possible as well, in particular coated with supra-conductive material such as graphene. The conductive layer may form electrical or electronical components, conductive traces, vias or the like.

For achieving at least one specific electric or electronic property, the manufacturing of the trace or the changing or reworking of a prefabricated trace is done based on models combining design parameters with desired electric or electronic properties, in particular the impedance.

It is further known that the key influence factors for the impedance of these traces are the copper thickness, the trace width, the material roughness, and the dielectric thickness. Material properties are, however, not considered as they are not process influenced. By using these factors, the impedance can be modelled, calculated and the trace is the produced, resulting in often a wide variation of the electric property under consideration, which can only be measured after the production process.

The CN 216565769 U discloses an intelligent circuit board etching device, which is suitable for the manufacturing process of a circuit board, the surface of the circuit board is provided with a copper layer, and the intelligent circuit board etching device comprises a copper thickness measuring device for measuring the thickness distribution of the copper layer on the surface of the circuit board; and the matrix type wet etching machine table is connected with the copper thickness measuring device and is used for non-uniformly etching the copper layer according to the thickness distribution of the copper layer and enabling the thickness of the copper layer to be uniform. By means of the intelligent circuit board etching device, the thickness of an electroplating copper layer can be effectively uniformized, and the precision and reliability of a non-uniformized thin copper manufacturing procedure can be improved through machine learning.

The US 2003088802 A1 discloses an apparatus and method are described for reducing the timing skew on a printed circuit board including a plurality of conductive traces interconnecting a first node and a second node. At least one section is removed from at least one printed circuit board trace to thereby sever a trace and prevent signals passing from the first node to the second node from following the severed trace. In this manner, signal path length can be adjusted to reduce timing skews in the circuit. Sections are removed from the traces by using a laser, CVD, a router, a plasma or by passing sufficient current through weakened areas of the traces.

The KR20070085202 A relates to a method for processing a substrate, comprising providing a multi-layer substrate, wherein the multi-layer substrate has a first surface, a second surface that opposes the first surface, and conductive paths extending from the first surface to the second surface. A portion of the first surface is covered with a conductive material after a smoothing step, followed by removing a portion of the conductive material to define conductive traces on the first surface, by laser trimming.

It is the object of the present invention to overcome the disadvantages of the prior art and to provide an improved method for fabricating structure layers, such as circuit traces, on component carriers, for instance printed circuit boards or IC substrates, in a dynamic process to ameliorate the production efficiency and to improve signal integrity and stability.

The scope of the present invention is as defined by the subject-matter of the independent claims. The dependent claims specify particular embodiments of the present invention.

According to the present invention, the proposed method is characterized by the steps of
- acquiring - preferably by measurement or detection method(s) - actual data from at least one (electrically) conductive structure layer of a component carrier,
- feeding said (acquired) actual data of said at least one (electrically) conductive structure layer into the at least one model, said model determining - in dependence of said actual data of said at least one conductive structure layer and in dependence of at least one electric or electronic target (i.e. pre-defined) property for the conductive structure layer - at least one adjusted design parameter for the conductive structure layer, wherein the at least one adjusted design parameter relates to a geometric characteristic (dimensions such as width, thickness, length and/or run) and/or structural characteristic (such as roughness and/or porosity and/or layered structure) and/or a material characteristic (such as type of material or material components) of the conductive structure layer, in particular the structure layer width, the structure layer thickness, the structure layer length, the structure layer roughness, the structure layer porosity and/or the structure layer material,
wherein the step of manufacturing a conductive structure layer or changing or reworking a pre-fabricated conductive structure layer is performed according to the at least one adjusted design parameter.

This allows the progress from a static model in manufacturing structure layers, such as electrically conductive traces, on component carriers to a real-time/active involvement through data driven processing during the manufacturing process until finishing the desired product with the desired properties. The drawbacks of know processes of evaluating the end product and being able to make adjustments only for the next to manufacture product or even product series can be omitted and production waste with properties deviating from the desired ones is prevented. Moreover, the present invention provides the advantage to decrease, preferably to eliminate, the variations among manufacturing lots and/or during production due to the proper adjustment of the parameter basing to actual time-by-time acquired data.

The model that determines at least one adjusted design parameter for the conductive structure layer may be or may comprise one or more algorithm(s) and/or one or more computing routine(s), and/or one or more feedback loop(s) and/or one or more calculation rule(s) and/or one or more association rule(s).

Moreover, the model may comprise and/or may be configured to retrieve a variety of background information, preferably information about - possible and/or optimized - characteristics of structure layers and/or (optimized) manufacturing steps and/or optimizing routines.

The model is preferably configured to determine the adjusted design parameter(s) according to pre-defined or self-capably developed optimization specifications or criteria.

The model may be a straight-forward model or a complex model. Preferably, the model is configured to provide artificial intelligence. The model may be implemented on a data processing device and/or data storage, preferably in form of a program, algorithm and/or routine.

Preferred, the material chosen for the electrically conductive structure layer(s) is copper based, in particular copper, where appropriate with at least one finishing layer made of at least one of gold, tin, palladium or nickel.

Preferred, the electrically conductive structure layer can be and/or can comprise a trace and/or a combination of (patterned) traces and/or a pad and/or a land and/or a connecting lip.

Preferred, the component carrier can be a printed circuit board (PCB) and/or a substrate (such as an IC substrate) and/or an interposer.

It is preferred, if the component carrier comprising the conductive structure layer from which said actual data are acquired (by measurement or detection method) is the same as the component carrier comprising the conductive structure layer that is manufactured, changed or reworked according to the at least one adjusted design parameter. In such a manner, the electric or electronic properties of the structure layer may be optimized directly within the (production) process.

Alternatively, it would be also possible, if the component carrier comprising the conductive structure layer from which said actual data are acquired (by measurement or detection method) is a different one as the conductive structure layer (or component carrier) that is manufactured, changed or reworked according to the at least one adjusted design parameter. In such a manner, the electric or electronic properties of a trace (or component carrier) may be optimized using (measurement and modelling) information retrieved from a conductive structure layer of another component carrier.

In a preferred embodiment said model determines or estimates - in dependence of said actual data of said at least one conductive structure layer - at least one electric or electronic property of said conductive structure layer and that said model adjusts at least one design parameter of the conductive structure layer, with the at least one adjusted design parameter reducing or eliminating the deviation between the determined or estimated electric or electronic property of said conductive structure layer and the (pre-defined) electric or electronic target property for the conductive structure layer. This may bring the advantage of manufacturing structure layers like e.g. traces having reliable mechanical and/or electronic properties due to at least one adjustment of at least one design parameter resulting in low deviation between the actual impedance and the required impedance.

In a preferred embodiment the model is an AI based model and/or that the target value of the model is at least one electric or electronic property for a conductive structure layer. This may bring the advantage of manufacturing structure layers which are less error-prone, since an AI based model may assess the actual data at least one time, preferably at least three times, during the manufacturing process.

In a preferred embodiment the step of manufacturing a conductive structure layer or changing or reworking a pre-fabricated conductive structure layer is performed in a dynamic production environment. This may bring the advantage of reducing the manufacturing steps, since adjustments may be done during the ongoing manufacturing process step.

In a preferred embodiment said model comprises at least one feedback loop into which said actual data of said at least one conductive structure layer are fed, and that the adjusted design parameter is based on at least one output from said at least one feedback loop, wherein preferably the feedback loop is part of a dynamic production environment. This embodiment may comprise the step of loading a (process) design parameter adjustment (full loop modelling) based on at least one output from said at least one feedback loop. This may bring the advantage of reducing the deviation of a property, for example impedance, between the actual data and the required value, since a multi-loop process may be performed.

Acquiring the actual data from the structure layer can be done by at least the capturing of at least one image of the structure layer, preferably using light in the visible range and/or X-ray radiation. Such a non-contact data acquisition method is least disturbing the production/reworking process. Visible light may be an easy way to detect exposed structures, whereas X-ray exploration allows to detect non-exposed/embedded structures. Even other spectral bands are possible for special purposes. Data acquisition is also possible by structure layer direct or indirect measurement through physical tools, e.g. pointers, or optical tools, preferably in the IR range, by electric values measurement, e.g. a two-four wires test or a ground measurement.

These, too, allow for a quick and sufficiently exact data acquisition with the least possible disturbance of the production process.

Preferred, with the data collected by for instance the above-given methods, a PE/CAM (Process Engineering/Computer Aided Manufacturing) system can be established, to create a faster and/or more precise production process, often allowing to minimize the required amount of res sources and/or raising efficiency.

A preferred embodiment relates to a method for fabricating at least one conductive circuit structure layer on or in a component carrier and with at least one specific electric or electronic property, comprising the step of manufacturing a conductive structure layer or changing or reworking a conductive structure layer, based on models combining design parameters with desired electric or electronic properties, in particular the impedance,
characterized by the steps of
- acquiring actual data from a conductive structure layer,
- establishing a dynamic production environment with at least one feedback loop,
- feeding said data into the at least one feedback loop,
- loading a process design parameter adjustment (full loop modelling) based on at least one output from said at least one feedback loop, and
- implementing said adjusted process design parameters in the fabricating process of the at least one conductive structure layer,
wherein the design parameters comprise at least one of the parameters determining the features of the structure layer, in particular at least one of the structure layer material, the structure layer width, the structure layer thickness, the structure layer length, the roughness, and the porosity.

This may bring the advantage of adjusting the feature of the trace, in order to fulfill the property requirements, for example impedance, using (multi-step) feedback loop(s). This may result in saving time, while on the other hand manufacturing reliable conductive layer structures using the described method.

A preferred embodiment of the invention is characterized by establishing a feedback loop into an AI based software environment and adjusting at least one design parameter guided by AI based software based on said feedback loop. This may bring the advantage of allowing a much faster deduction of adjusting the most relevant parameters, in particular to adjust for best results of actual signal performance, in the most appropriate manner than could be done by human or common electronical computing means.

Most preferred, the parameters that may be processed by AI are the (plating) thickness of the structure layer, structure layer pattern design parameters, structure layer surface (roughness, porosity) and material treatment. In case of impedance as the target property of the structure layer, this brings the advantage of addressing the most relevant design parameters that are determining the mass of the structure layer, e.g. the material and the length of the structure layer.

A further embodiment of the invention is characterized by establishing a feedback loop of at least one structure layer parameter into an AI based software environment and trimming at least one parameter of the structure layer or adjusting at least one parameter of the structure layer using at least one input received by the AI based software set in association of said feedback loop. This allows to rework or adjust pre-manufactured structure layers still in the production process and to reduce production waste.

With this embodiment it is of advantage to provide for adjusting the structure layer width and/or the structure layer thickness and/or the structure layer length by laser trimming or trimming by at least one chemical process, with the advantage of applying a highly effective, fast and exact method for material ablation. Thus, the structure layer manufacturing/reworking process is extended with a dynamic option by leveraging the life data paired with a laser-based solution to trim the structure layers in order to meet all exigences regarding tolerances and electrical property targets of the structure layers.

Other than that, according to a further embodiment of the invention, adjusting the structure layer width and/or the structure layer thickness and/or the structure layer length could be done by at least one additive manufacturing processes. This allows for achieving a product with design parameters for the desired properties even if in the first instance there was less structure layer material applied than needed.

The method according to a still further embodiment of the present invention preferably includes a step of inputting the measurement data of at least one design parameter of said conductive structure layer and the value of at least one electric or electronic property into the AI based software environment. This may further contribute to the advantage of allowing a much faster deduction of adjusting the most relevant parameters, in particular to adjust for best results of actual signal performance, in the most appropriate manner than could be done by human or common electronical computing means.

An advantageous version of the method according to the invention is characterized by LDI (Laser Direct Imaging) based structure layer/spacing processing based on actual structure layer feature input from AI based software. This may bring the advantage of applying a highly effective, fast and exact method for material deposition with finest structures.

Preferred, the method provides for collecting at least one-dimensional data of the conductive structure layer and modelling at least one design parameter based on actual dielectric values. In particular, the structure layer thickness and/or cross section (width of the cross section and/or cross sectional area) are considered. Further parameters that may be processed by AI are the (plating) thickness of the structure layer, structure layer pattern design parameters, structure layer surface (roughness, porosity) and material treatment. This allows for the quick determination and adjustment of the most relevant design parameters that are determining the desired property of the structure layer, in particular for impedance being the mass of the structure layer, e.g. the material and the length of the structure layer.

The above-given features of the present invention allow an AI based dynamic structure layer/space modelling, with actual structure layer data to be collected and used to accurately model the required value for at least one adjustable structure layer parameter based on actual electric or electronic values of said structure layer. In particular, the signal properties and/or impedance of the structure layer or a group of structure layers with interstitial gaps can be modelled based on AI infused data models and previously etched structure layers are reworked, in particular by means of laser trimming, to its optimum. Trimming can be done in all directions, with adjustment of preferably width, thickness and even length of the structure layer, in case of X/Y trimming to result in serpentine form of the reworked structure layer.

The object of the present invention can also be achieved by a computer-implemented method for automatically executing the above-explained process steps, allowing for all the advantages discussed already in the above paragraphs.

Thus, the invention also relates to a computer-implemented method for determining at least one design parameter for at least one (electrically) conductive structure layer on or in a component carrier and with at least one specific electric or electronic property, used for manufacturing the conductive structure layer or changing or reworking a prefabricated conductive structure layer, based on at least one model combining design parameters with at least one electric or electronic property, in particular the impedance, the method comprising the steps of
- receiving actual data acquired from at least one (electrically) conductive structure layer of a component carrier,
- feeding said data into at least one model, said model determining - in dependence of said actual data of said at least one conductive structure layer and in dependence of at least one pre-defined electric or electronic property for the conductive structure layer - at least one adjusted design parameter for the conductive structure layer, wherein the at least one adjusted design parameter relates to a geometric characteristic and/or structural characteristic and/or a material characteristic of the conductive structure layer, in particular the structure layer width, the structure layer thickness, the structure layer length, the structure layer roughness, the structure layer porosity and/or the structure layer material

In a preferred embodiment said model comprises at least one feedback loop into which said actual data of said at least one conductive structure layer are fed, and that said at least one design parameter for the conductive structure layer is adjusted based on at least one output from the at least one feedback loop. This may bring the advantage of reducing the deviation of a property, for example impedance, between the actual data and the required value, since a multi-loop process may be performed. According to the present invention, a computer device is provided comprising means for carrying out the above-explained method. This may bring the advantage of having the possibility to adapt every existing production lines with computer controlled operation.

The object of the present invention can also be achieved by executing the method in a production facility for fabricating or reworking at least one copper-based circuit structure layer on or in a component carrier and with at least one specific electric or electronic property, comprising equipment for manufacturing a structure layer or changing or reworking a prefabricated structure layer. Said facility will further comprise means for performing the above-explained method. This may bring the advantage of reducing the manufacturing steps, since adjustments may be performed during the same manufacturing process.

Preferred, said production facility will comprise a computer device for controlling production facility for the manufacturing of a structure layer or changing or reworking of a prefabricated structure layer. According to the present invention, said computer device will be construed for controlling the facility and its processing means to execute the above-explained method.

With a computer program product, containing computer readable instructions, devices and/or facilities equipped with computer devices can be used for manufacturing a structure layer or changing or reworking a prefabricated structure layer according to a process according to the invention and outlined above, when said instruction are executed by a computer device.

According to the present invention, a further feature is a computer readable medium containing code for manufacturing a structure layer or changing or reworking a prefabricated structure layer according to a process defined above, when the code is executed by the computer device. This code can also be adapted to control a computer device for controlling a facility for manufacturing a structure layer or changing or reworking a prefabricated structure layer according to a process as defined above when the code is executed by the computer device. The technical effects and advantages were already explained above, in connection with the process and the arrangement according to the invention.

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures, for instance traces, pads or the like, are made of metal, for example copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a component carrier, preferably a printed circuit board, a component carrier is usually configured for accommodating one or more components on one or both opposing surfaces of the (e.g. plate-shaped) component carrier. They may be connected to the respective main surface by soldering. A dielectric part of a PCB may be composed of resin with reinforcing fibers (such as glass fibers).

The component carrier may additionally comprise a substrate (in particular an IC substrate). In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with component carrier, such as a printed circuit board or intermediate printed circuit board). Thus, the term "substrate" also includes "IC substrates". A dielectric part of a substrate may be composed of resin with reinforcing spheres (such as glass spheres).

The at least one electrically insulating layer structure can comprise at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

The at least one component can be selected from a group consisting of e.g. an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microe-lectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a soft magnetic element, in particular a ferromagnetic element, an antiferromagnetic element or a ferrimagnetic element, for instance a ferrite core or may be a paramagnetic element. However, the component may also be a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked, in particular parallel stacked, and connected together by applying a pressing force, if desired accompanied by heat. The component carrier may be configured to carry further electric and/or electronic components, such as resistances, capacitors, diodes, transistors, or integrated circuits.

Embodiments of the present invention are now described with reference to the accompanying drawings. The invention is not limited to the illustrated or described embodiments.
- Fig. 1: Shows in schematic manner a facility for performing the process according to the invention
- Fig. 2: Shows a block diagram with the essential steps of the method according to the invention

The invention can be applied to any product which requires e.g. impedance measurements throughout various applications and industries. The proposed method is especially interesting for 5G devices or other high frequency applications.

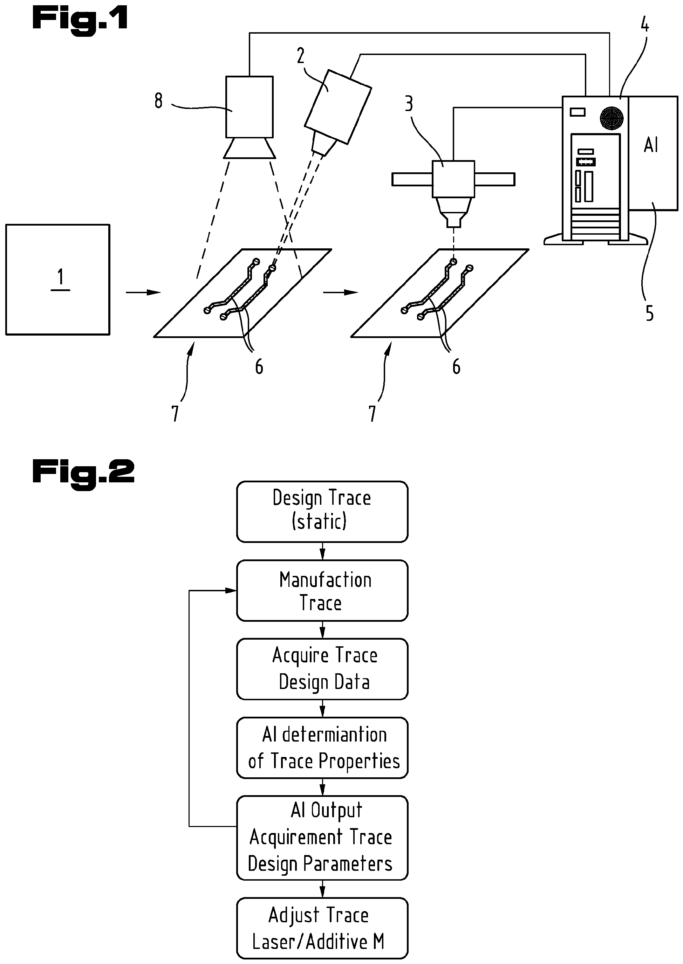

The method for fabricating at least one conductive circuit structure layer 6, for instance a trace or at least a longitudinal section of a trace, on or in a component carrier 7, for instance a printed circuit board, and with at least one specific electric or electronic property, as in its essential steps shown in the block diagram of Fig. 2, comprises the step of manufacturing a conductive structure layer 6 or changing or reworking a prefabricated conductive structure layer 6. Such structure layers are produced based on models combining design parameters with desired electric or electronic properties, in particular the impedance.

The next step in the process according to the invention is to acquire - preferably by measurement or detection method(s) or any kind of equivalent input - actual data from at least one conductive structure layer of a component carrier (see as an exemplary embodiment an imaging device 8, such as a camera, in Fig. 1). This can be done in particular comprising capturing one or more images of the structure layer. The capturing of at least one image of the structure layer may be done preferably using light in the visible range and/or using X-ray radiation, allowing to detect in the visible light range exposed structures and/or in the X-ray range non-exposed/embedded structures. Even other spectral bands may be used for special purposes. The structure layer measurement can be done also by direct and/or indirect measurement also through physical tools like pointers or by optical tools, preferably using the IR-range. Further, electric values measurement, e.g. a two-four wires test, or a ground measurement could be provided for data acquisition in this early stage.

In a next step said (acquired) actual data of said at least one conductive structure layer are fed into at least one model, said model determining - in dependence of said actual data of said at least one conductive structure layer and in dependence of at least one predefined electric or electronic property for the conductive structure layer - at least one adjusted design parameter for the conductive structure layer, allowing to preferably establish a PE/CAM (Process Engineering/Computer Aided Manufacturing) system. The at least one adjusted design parameter may relate to a geometric characteristic and/or a material characteristic of the conductive structure layer, in particular the structure layer width, the structure layer thickness, the structure layer length, the structure layer roughness, the structure layer porosity and/or the structure layer material. The method is further characterized in that the step of manufacturing a conductive structure layer or changing or reworking a pre-fabricated conductive structure layer is performed according to the at least one adjusted design parameter. It is preferred, if the component carrier comprising the conductive structure layer from which said actual data are acquired (by measurement or detection method) is the same as the component carrier comprising the conductive structure layer that is manufactured, changed or reworked according to the at least one adjusted design parameter. In such a manner, the electric or electronic properties of the structure layer may be optimized directly within the (production) process.

Alternatively, it would be also possible, if the component carrier comprising the conductive structure layer from which said actual data are acquired (by measurement or detection method) is a different one as the conductive structure layer (or component carrier) that is manufactured, changed or reworked according to the at least one adjusted design parameter. In such a manner, the electric or electronic properties of a structure layer (or component carrier) may be optimized using (measurement and modelling) information retrieved from a conductive structure layer of another component carrier.

In a preferred embodiment said model determines or estimates - in dependence of said actual data of said at least one conductive structure layer - at least one electric or electronic property of said conductive structure layer and that said model adjusts at least one design parameter (e.g. geometrical dimension or material selection) of the conductive structure layer, with the at least one adjusted design parameter reducing or eliminating the deviation between the determined or estimated electric or electronic property of said conductive structure layer and the (pre-defined) electric or electronic target property for the conductive structure layer.

In a preferred embodiment the model is an AI based model and/or that the target value of the model is at least one electric or electronic property for a conductive structure layer.

In a preferred embodiment the step of manufacturing a conductive structure layer or changing or reworking a pre-fabricated conductive structure layer is performed in a dynamic production environment.

In a preferred embodiment said model comprises at least one feedback loop into which said actual data of said at least one conductive structure layer are fed, and that the adjusted design parameter is based on at least one output from said at least one feedback loop, wherein preferably the feedback loop is part of a dynamic production environment.

Other than in standard structure layer manufacturing processes, and leading away from known methods, there may be established a dynamic production environment with at least one feedback loop, into which loop the data acquired from and about the structure layer are fed back. Most of advantage is a feedback loop into an AI based software environment and adjusting at least one parameter guided by AI based software based on said feedback loop. The main feature to take into consideration is the data-based model being trained by any suitable algorithm (e.g. by a machine learning method such as artificial (deep) neuronal net, Bayesian Algorithms, Clustering Algorithms etc.) in order to rank the feedbacks and the eventual variables to adapt the subsequent performances evaluation/calculation/modification. In particular, most relevant parameters that can be processed by the AI system are at least one of the group of the (plating) thickness, the structure layer pattern design parameters, the structure layer surface (roughness, porosity) or the material treatment.

The manufacturing, adjustment or reworking of the structure layer is then performed with at least one adjusted process design parameter loaded after the AI system has processed the acquired data and relating them to the desired properties of the structure layer. That means that said process design parameter is based on at least one output from said at least one feedback loop and is implemented in the fabricating process of the at least one conductive structure layer.

Preferred, the design parameter comprises at least one of the parameters determining the features of the structure layer, in particular at least one of the structure layer material, the structure layer width, the structure layer thickness, the structure layer length, the roughness, and the porosity. All these parameters are most relevant design parameters that are determining the mass of the structure layer, which itself is determining such important property as the impedance of the structure layer.

The output from the AI system, i.e. the target design parameter as the output from the AI feedback loop, can be used already for dynamic etching compensation. This is symbolized by the feedback arrow in the block diagram of Fig. 2. Further, other processes used in the manufacturing of the structure layer can be adapted, adjusted or compensational measures in such processes can be provided, these processes including for instance desmearing (method of cleaning surfaces on circuit boards from impurities and luting, occurring during processing the board), adhesion promotion, lithography, trenching, 3D printing or plating.

For the acquired structure layer parameters a feedback loop back into an AI based software environment established. At least one parameter of the structure layer is trimmed or adjusted by using at least one input received by said AI based software and set in association of said feedback loop. This could include adjusting the structure layer width and/or the structure layer thickness and/or the structure layer length by laser trimming or trimming by chemical processes in case material has to be ablated. On the other hand, if the AI based software has determined that additional material has to be deposited to give structure layer design parameters leading to the desired properties, adjusting the structure layer width and/or the structure layer thickness and/or the structure layer length could also be performed by additive manufacturing processes.

To allow for an optimum adjustment, the measurement data of at least one design parameter and the value of at least one electric or electronic property are inputted into the AI based soft-ware environment. At least one dimensional data of the structure layer can be collected and at least one design parameter can be modelled based on actual dielectric values.

One very advantageous method for laser-based structure layer design parameter adjustment or processing that can be based on the actual structure layer data input from the AI based soft-ware, in particular structure layer thickness data, is Laser Direct Imaging (LDI). This method is especially of advantage considering the component carriers becoming smaller and smaller and only uses a computer-controlled, highly focused, laser beam to directly define the circuit pattern onto the board. After the panel has been coated with a layer of photoresist, the filed defining the pattern are preloaded into the control of the CNC laser, which digitally creates the pattern onto the board. Thereafter, the areas not exposed to the laser beam are then etched, leaving intact the circuit structure layers.

The essential concept of the invention lies in a dynamic production environment with feedback loops for actual data to result in preferably AI based process parameter adjustment (full loop modelling).

All of the above-explained process steps and AI based evaluations may be performed as a computer-implemented method. Not only the models combining design parameters of structure layers to be manufactured, adjusted or reworked with the desired electric or electronic properties, in particular the impedance, are calculated using computer devices. These computer devices accordingly are determining design parameters for at least one conductive circuit structure layer on or in a component carrier and with at least one specific electric or electronic property and are preferably used for controlling the production facility for manufacturing the structure layer or changing or reworking a prefabricated structure layer, based on said models.

Furthermore, also the steps of receiving actual data acquired from a structure layer, feeding said data into at least one feedback loop, and adjusting said design parameters for the structure layer based on at least one output from one of said feedback loops, are also performed in a computer-implemented manner with a computer device designed to perform these process steps. The design parameters considered by the computer-implemented method comprise at least one of the parameters determining a feature of the structure layer, in particular at least one of the structure layer width, the structure layer thickness, the structure layer length, the roughness, and the porosity.

The computer-implemented method will preferably also comprise the following steps, which are performed automatically and by a computer device designed accordingly:
- acquiring actual data from a structure layer comprises at least one of: capturing at least one image of the structure layer, structure layer direct or indirect measurement through physical tools, e.g. pointers, or optical tools, preferably in the IR range, electric values measurement, e.g. a two-four wires test or a ground measurement,
- establishing a feedback loop into an AI based software environment and adjusting at least one parameter guided by AI based soft-ware based on said feedback loop,
- establishing a feedback loop of structure layer parameters into an AI based software environment and trimming at least one parameter of the structure layer or adjusting at least one parameter of the structure layer using at least one input received by AI based software set in association of said feedback loop,
- adjusting the structure layer width and/or the structure layer thickness and/or the structure layer length by laser trimming or trimming by chemical processes,
- adjusting the structure layer width and/or the structure layer thickness and/or the structure layer length by additive manufacturing processes,
- inputting the measurement data of at least one design parameter and the value of at least one electric or electronic property into the AI based software environment,
- LDI (Laser Direct Imaging) based structure layer/spacing processing based on actual copper thickness input from AI based software,
- collecting at least one-dimensional data of the structure layer and modelling at least one design parameter based on actual dielectric values.

To perform all of the above-enumerated tasks, a computer device is provided comprising means for carrying out the described computer-implemented method. Preferably, said computer device is running an AI based software or is connected to such system, for performing preferably all the steps starting with calculating the models combining design parameters of structure layers to be manufactured, adjusted or reworked with the desired electric or electronic properties, in particular the impedance, and comprising also controlling the production facility for manufacturing the structure layer or changing or reworking a prefabricated structure layer, based on said models, further the steps of receiving actual data acquired from a structure layer, feeding said data into at least one feedback loop, and adjusting said design parameters for the structure layer based on at least one output from one of said feedback loops, are also performed in a computer-implemented manner with a computer device designed to perform these process steps. The design parameters considered by the computer-implemented method comprise at least one of the parameters determining a feature of the structure layer, in particular at least one of the structure layer width, the structure layer thickness, the structure layer length, the roughness, and the porosity.

The computer device is also designed to acquire actual data from a structure layer, controlling and receiving image data of the structure layer, and/or acquiring data by at least one of direct or indirect structure layer parameter measurement through physical tools, e.g. pointers, or optical tools, preferably in the IR range, and/or by electric values measurement, e.g. a two-four wires test or a ground measurement. The computer device is further designed for establishing a feedback loop into an AI based software environment, and for this purpose is running an AI software or is connected to such system.

Due to these computer device features said device is designed to calculate adjustments of at least one parameter guided by AI based software based on said feedback loop, establishing a feedback loop of structure layer parameters into an AI based software environment and controlling the trimming of at least one parameter of the structure layer or adjusting at least one parameter of the structure layer using at least one input received by AI based software set in association of said feedback loop.

Laser devices can be controlled by the computer device for adjusting the structure layer width and/or the structure layer thickness and/or the structure layer length by laser trimming or trimming by chemical processes, as well as means for additive manufacturing processes can be controlled by the computer device for adjusting the structure layer width and/or the structure layer thickness and/or the structure layer length by additive processes. In a preferred embodiment multiple laser devices may be used. Each of them may use different wavelength and/or different amount of laser pulses and/or different time (length) of laser pulses. Moreover, multiple camera/detection sensors may be used in order to further distinguish the various component carrier and/or track them. In this case it is preferred, if a proper identification code may be assembled in or on the component carrier.

Preferably, the computer device designed according to the invention can also receive measurement data of at least one design parameter and the value of at least one electric or electronic property from appropriate measurement devices and can transfer these data into the AI based software environment run by the computer device itself or by a system connected to the computer device. Preferably, also a LDI (Laser Direct Imaging) device for structure layer/spacing processing based on actual copper thickness input from AI based software can be controlled by the computer device, and/or the computer device is designed to receive input from systems for collecting at least one-dimensional data of the structure layer and for modelling at least one design parameter based on received actual dielectric values.

The actual carrying out of the above-described process steps will preferably be made in a production facility for fabricating at least one copper-based circuit structure layer 6 on or in a component carrier 7 and with at least one specific electric or electronic property, comprising equipment for manufacturing a structure layer or changing or reworking a prefabricated structure layer. Said facility can, as for example shown in Fig. 1, for this purpose, comprise equipment or production lines 1, respectively, for desmearing, adhesion promotion, lithography, trenching or plating. For performing Laser Direct Imaging (LDI) to manufacture or rework the structure layers on the component carriers a CNC laser device can be provided, as well as equipment for laser trimming 2 of the structure layers and/or adjustment of the structure layers by additive manufacturing processes 3. All these means are designed for performing the method described above and based on dynamic production adaptation based on AI software feedback loops with input of the actual data acquired from the structure layers 6, for example by an imaging device 8 (e.g. camera). Preferably, the production facility and at least part of its equipment is controlled by a computer device 4, preferably designed as described above, including or connected to a model 5 (such as an AI software), which computer device 4 also receives the input from one or more equipment(s), such as an imaging device 8 (e.g. camera), for acquiring data from the structure layers 6 to be manufactured, adjusted or reworked.

All code for controlling the production facility, at least part of its equipment and also the code for the AI software and calculation software for all kinds of models for the structure layers and the necessary parameter adjustments and input data evaluation is comprised in a computer program product that can be executed by a common or dedicated computer device. Said code can also be stored on a computer readable medium of any kind, and can be loaded into a computer device for controlling a facility for fabricating at least one conductive circuit structure layer on or in a component carrier and with at least one specific electric or electronic property, to perform a method of manufacturing a structure layer or changing or reworking a pre-fabricated structure layer, based on models combining design parameters with desired electric or electronic properties, in particular the impedance, characterized by the steps of acquiring actual data from a structure layer, establishing a dynamic production environment with at least one feedback loop, feeding said data into the at least one feedback loop, loading a process design parameter adjustment (full loop modelling) based on at least one output from said at least one feedback loop, and implementing said adjusted process design parameters in the fabricating process of the at least one conductive structure layer, with preferably establishing a feedback loop into an AI based software environment and adjusting at least one parameter guided by AI based software based on said feedback loop.

### List of reference numerals

- 1: Production line
- 2: Laser trimming device
- 3: Additive manufacturing device
- 4: Computer device
- 5: Model determining at least one adjusted design parameter for the conductive structure layer 6
- 6: Structure layer
- 7: Component carrier
- 8: Imaging device

## Claims

1. A method for fabricating at least one conductive structure layer (6), preferably in the form of a trace, a pad, a land or a connecting lip, on or in a component carrier (7), preferably in the form of a printed circuit board or an integrated circuit substrate, and with at least one specific electric or electronic property, comprising the step of manufacturing a conductive structure layer (6) or changing or reworking a pre-fabricated conductive structure layer (6), based on at least one model (5) combining design parameters with at least one electric or electronic property, in particular the impedance,
wherein the method further comprises the steps of
- acquiring actual data from at least one conductive structure layer (6) of a component carrier (7),
- feeding said actual data of said at least one conductive structure layer (6) into the at least one model (5), said model (5) determining - in dependence of said actual data of said at least one conductive structure layer (6) and in dependence of at least one electric or electronic target property for the conductive structure layer (6) - at least one adjusted design parameter for the conductive structure layer (6), wherein the at least one adjusted design parameter relates to a geometric characteristic and/or a structural characteristic and/or a material characteristic of the conductive structure layer (6), in particular the structure layer width, the structure layer thickness, the structure layer length, the structure layer roughness, the structure layer porosity and/or the structure layer material,
wherein the step of manufacturing a conductive structure layer (6) or changing or reworking a pre-fabricated conductive structure layer (6) is performed according to the at least one adjusted design parameter.

2. A method according to claim 1, **characterized in that** said model (5) determines or estimates
- in dependence of said actual data of said at least one conductive structure layer (6) - at least one electric or electronic property of said conductive structure layer (6) and that said model adjusts at least one design parameter of the conductive structure layer (6), with the at least one adjusted design parameter reducing or eliminating the deviation between the determined or estimated electric or electronic property of said conductive structure layer (6) and the electric or electronic target property for the conductive structure layer (6).

3. A method according to claim 1 or 2, **characterized in that** the model is an AI based model and/or that the target value of the model is at least one electric or electronic property for a conductive trace.

4. A method according to one of the preceding claims, **characterized in that** the step of manufacturing a conductive structure layer (6) or changing or reworking a pre-fabricated conductive structure layer (6) is performed in a dynamic production environment.

5. A method according to one of the preceding claims, **characterized in that** said model (5) comprises at least one feedback loop into which said actual data of said at least one conductive structure layer (6) are fed, and that the adjusted design parameter is based on at least one output from said at least one feedback loop, wherein preferably the feedback loop is part of a dynamic production environment.

6. A method according to one of the preceding claims, **characterized in that** acquiring actual data from a conductive structure layer (6) comprises at least the capturing of at least one image of the structure layer, preferably using light in the visible range and/or X-ray radiation, and/or structure layer direct or indirect measurement through physical tools, e.g. pointers, or optical tools, preferably in the IR range, and/or electric values measurement, e.g. a two-four wires test or a ground measurement.

7. A method according to one of the preceding claims, **characterized by** establishing a feedback loop into an AI based software environment and adjusting at least one design parameter guided by AI based software based on said feedback loop.

8. A method according to one of the preceding claims, **characterized by** establishing a feedback loop of structure layer parameters into an AI based software environment and trimming at least one parameter of the structure layer (6) or adjusting at least one parameter of the structure layer (6) using at least one input received by AI based software set in association of said feedback loop.

9. A method according to one of the preceding claims, **characterized by** inputting the measurement data of at least one design parameter of said conductive structure layer (6) and the value of at least one electric or electronic property into the AI based software environment.

10. A method according to one of the preceding claims, **characterized by** LDI (Laser Direct Imaging) based structure layer/spacing processing based on actual copper thickness input from AI based software.

11. A computer-implemented method for determining at least one design parameter for at least one conductive structure layer (6), preferably in the form of a trace, a pad, a land or a connecting lip, on or in a component carrier (7), preferably in the form of a printed circuit board or an integrated circuit substrate, and with at least one specific electric or electronic property, used for manufacturing the structure layer (6) or changing or reworking a prefabricated structure layer (6), based on at least one model (5) combining design parameters with at least one electric or electronic property, in particular the impedance, the method comprising the steps of
- receiving actual data acquired from at least one conductive structure layer (6) of a component carrier (7),
- feeding said data into at least one model (5), said model (5) determining - in dependence of said actual data of said at least one conductive structure layer (6) and in dependence of at least one predefined electric or electronic property for the conductive structure layer (6) - at least one adjusted design parameter for the conductive structure layer (6), wherein the at least one adjusted design parameter relates to a geometric characteristic and/or structural characteristic and/or a material characteristic of the conductive structure layer (6), in particular the structure layer width, the structure layer thickness, the structure layer length, the structure layer roughness, the structure layer porosity and/or the structure layer material.

12. A computer-implemented method according to claim 11, **characterized by** any of the method steps of claims 2 to 10.

13. A computer device (4) comprising means for carrying out the method according to one of the claims 1 to 12.

14. A computer program product, for manufacturing a conductive structure layer or changing or reworking a prefabricated conductive structure layer (6) according to a method defined in any of claims 1 to 12, when executed by a computer device.

15. A computer program product, for controlling a facility for manufacturing a conductive structure layer (6) or changing or reworking a prefabricated conductive structure layer (6) according to a method defined in any of claims 1 to 12, when executed by a computer device (4).
